Europäisches Patentamt

European Patent Office

Office européen des brevets

(11) Publication number: **0 066 409**
**B1**

# EUROPEAN PATENT SPECIFICATION

(45) Date of publication of patent specification: **02.03.88**

(21) Application number: **82302533.3**

(22) Date of filing: **18.05.82**

(51) Int. Cl.⁴: **H 01 J 37/073, H 01 J 37/24**

(54) **Charged particle source.**

(30) Priority: **22.05.81 JP 76502/81**

(43) Date of publication of application:
**08.12.82 Bulletin 82/49**

(45) Publication of the grant of the patent:
**02.03.88 Bulletin 88/09**

(84) Designated Contracting States:
**DE FR GB NL**

(56) References cited:
**DE-A-2 942 386**
**DE-B-1 012 393**
**GB-A-1 325 552**
**US-A-3 617 739**
**US-A-3 619 608**
**US-A-3 665 241**
**US-A-3 786 268**
**US-A-3 930 155**
**US-A-3 984 692**

**PATENTS ABSTRACTS OF JAPAN, vol. 5, no. 40, 17th March 1981, page 712E49 & JP-A-55165542**

**SOVIET PHYSICS - TECHNICAL PHYSICS, vol. 14, no. 8, February 1970, pages 1134-1139, New York, US; E.G.SHIROKOV: "Increasing the total filed-emission current"**

(73) Proprietor: **Hitachi, Ltd.**
**5-1, Marunouchi 1-chome**
**Chiyoda-ku Tokyo 100 (JP)**

(72) Inventor: **Hosoki, Shigeyuki**
**168-58-48-24 Shimo-yugi**
**Hachioji-shi Tokyo (JP)**
Inventor: **Futamoto, Masaaki**
**2646-2 Kawajiri Shiroyama-cho**
**Tsukui-gun Kanagawa-ken (JP)**
Inventor: **Kawabe, Ushio**
**1-8-46 Sakae-cho Hamuramachi**
**Nishitama-gun Tokyo (JP)**
Inventor: **Ishitani, Tohru**
**1354-56-R304, Irumagawa**
**Sayama-shi Saitama-ken (JP)**
Inventor: **Tamura, Hifumi**
**10-8 Kiyokawa-cho**
**Hachioji-shi Tokyo (JP)**

(74) Representative: **Paget, Hugh Charles Edward et al**
**MEWBURN ELLIS & CO. 2/3 Cursitor Street**
**London EC4A 1BQ (GB)**

Courier Press, Leamington Spa, England.

# Description

The present invention relates to a charged particle source in an instrument column in particular for microfabrication processes.

The field emission cathode (electron source) and the field ionization ion source have in the past been used in totally different types of equipment, although they have the same shape of tip. This is because the polarity of the charged particles generated by the electron source is opposite to that of the ion source and the current characteristics of the two sources are different. In microfabrication processes in the micron and sub-micron ranges, it is desirable that the characteristics of both electron beams and ion beams are applied in lithography and fabrication and that ion beam lithography and microdoping by ion implantation be performed in a vacuum in which also electron beams are used, while the operator can watch the whole process. To meet these requirements the best solution is to employ a tip that can be used both as an electron source and an ion source. The difficulties in providing a convenient design for such a charged particle source are discussed below.

US—A—3 665 241 describes field-forming structures having an array of closely spaced cones with sharp points. These structures can be used as field ionizers and field emission cathodes.

The tip material that has been widely used as an electron source as well as an ion source is tungsten (W). This material, however, has certain problems. When a tungsten tip is used as an ion source, the chemical reaction between the tip surface and hydrogen gas makes it impossible to use it for a long period of time. When, on the other hand, the tungsten tip is used as an electron source, the emitted electrons ionize the residual gas molecules in the vacuum space and these ions are accelerated, as opposed to the electrons, to bombard the tip thereby increasing instability of field emission current. Thus, the material used as electron source must have sufficient strength to undergo bombardment by ions. Tungsten, however, cannot be said to meet this requirement.

Soviet Physics-Technical Physics, Vol. 14, No. 8 (February 1970) pages 1134—9, E.G. Shirokov, mentions that carbides and borides, especially ZrC and $LaB_6$ can be used as tips to increase field emission current, without destruction of the tip.

The object of this invention is to provide a charged particle source which can be operated either as an electron source or an ion source and which is adapted and arranged for convenient operation in association with an instrument column.

The invention is defined in claim 1.

A detailed explanation of the invention, and a specific embodiment thereof, will be given below, with reference to the accompanying drawings, in which:—

Figure 1 is a schematic diagram illustrating the principle of the charged particle source used in this invention; and

Figure 2 is a schematic diagram of one embodiment of this invention.

The tip material used in this invention, is selected from materials such as TiC, ZrC, HfC, VC, NbC and TaC, ZrN, HfN, VN, NbN and TaN, $TiB_2$, $ZrB_2$, $HfB_2$, $VB_2$, $NbB_2$ and $TaB_2$, and $LaB_6$, $CeB_6$, $PrB_6$, $NdB_6$, $SmB_6$ and $EuB_6$. While the carbides and nitrides listed above have a metal-to-C or N ratio of 1:1, it is possible to use as the tip material such non-stoichiometric compounds as $TiC_{0.8}$ or $ZrC_{0.9}$. It is, however, preferable to use the materials that have a chemically stable ratio of 1:1. Since these materials are extremely hard, it is also preferable for manufacturing reasons to use a single crystal whisker for the tip.

It is known that some of these materials may be used as an electron emission cathode. What has led to the present invention is the discoveries that these materials can be used both as a stable electron source and as an ion source; that the reaction of these material with hydrogen gas is much smaller than in the case of tungsten when they are used as an ion source; and that when they are used as an electron source current stability is improved because of their small ion sputtering rate.

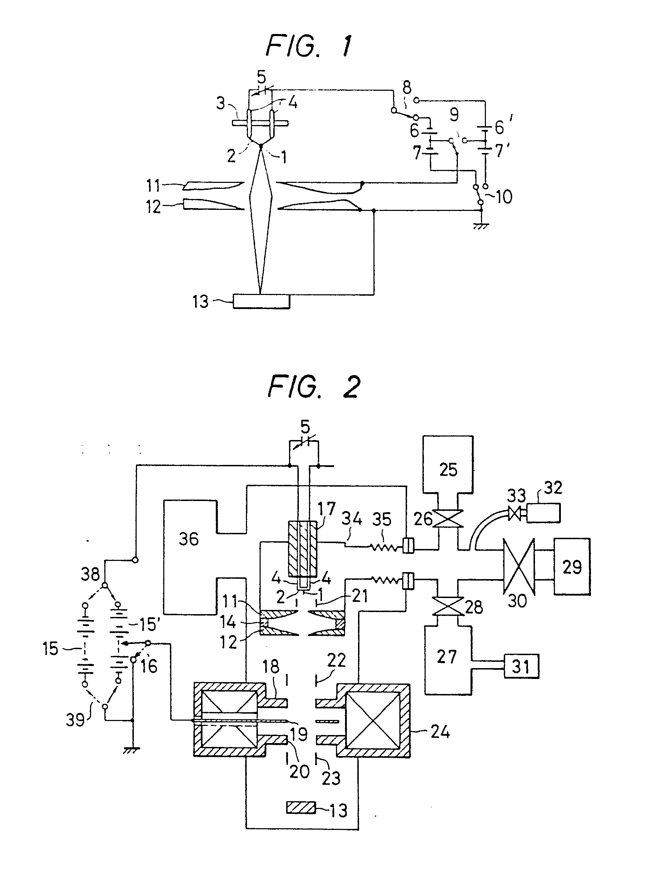

Figure 1 illustrates the simplified principle of the charged particle source used in this invention in a simplified form. A tip 1 is placed in contact with a filament 2 which acts as a support, a heater and a heat-conductor. The filament 2 is in turn bonded to a stem 4 secured to an insulator base 3. Though this is not shown in Figure 1, the heat-conductor is connected to a cooling stage of a small freezer. In this way the temperature of the tip 1 can be varied from a few K to 2000 K. A voltage source 6 or 6' is connected between the tip 1 and a first electrode 11 to produce an electric field around the tip and the charged particles thus generated are drawn out and attracted by the first electrode 11. A second voltage source 7 or 7' is connected between the first electrode 11 and a second electrode 12 to accelerate the charged particles drawn out by the first electrode and converge them onto a specimen or work piece 13. The first electrode 11 and the second electrode 12 constitute an electrostatic lens. The switches 8, 9 and 10 are used to select the appropriate electric power sources. When the electric power sources 6 and 7 are used, electron beams are produced. When the power sources 6' and 7' are used, ion beams are produced. A power source 5 heats the filament 2.

There are two major possible problems encountered in designing a specific embodiment of the present invention. The structure of the beam source should be the same for both field emission (electron source) and the field ionization (ion source). It is, however, desirable that the vacuum pressure for field emission be lower than $10^{-9}$ Torr while field ionization requires the vacuum pressure of approximately $10^{-4}$ Torr (though it may vary slightly depending on the gas used). This difference of vacuum pressure is a problem when it is desired to use the same tip as an electron source and an ion source with a swift change over the switches.

Secondly, in electron optical systems an electro-magnetic lens with a small aberration is used to minimize aberration, while in ion optical systems an electrostatic lens is used because the effect of an electromagnetic lens under a conventional magnetic field is too small due to the mass of the ions. Thus, the selection of one of these lens systems will not provide characteristics which are optimum for both the electrons and ions.

The specific embodiment of this invention described in the following overcomes both these difficulties and enables the generation of both the electrons and ions with a single device.

Figure 2 shows this embodiment. A charged particle generating chamber 34 is placed under a vacuum in the instrument column and has aperture holes in first and second electrodes 11, 12. The volume of the chamber 34 is about 200 ml. For field emission, an evacuating pump 25 such as an ion pump is used to achieve an ultra-high vacuum as in conventional devices. For field ionization a gas is introduced to obtain the desired pressure. The aperture holes of the first and second electrodes 11, 12 are made sufficiently small so that the increase in pressure in the instrument column can be kept small, i.e. the pressure in the instrument column will be of the order of $10^{-6}$ to $10^{-7}$ Torr.

Gas is introduced from the gas reservoir 32 by opening the valve 33. Gas evacuation is done by an oil diffusion pump 27 which has a high evacuating rate by opening its valve 28 and closing the valve 26 of the ion pump 25. However, since the volume of the chamber 34 is small, the diffusion pump does not require a large evacuating power as is required in conventional devices and therefore a single diffusion pump that can achieve an ultra-high vacuum may be used to perform the functions of the two pumps 25 and 27. In this way, because of the small volume of the chamber 34, switching from ion source operation to electron source operation can easily be effected.

The focusing lens system for electrons or ions is provided by the first and second electrodes 11, 12. The diameter of the focused beam is about 0.1 μm for electrons and about 0.3 μm for ions. To obtain smaller diameter beams a lower focusing lens (objective lens) 24 is used. The electrodes 18 and 20 of the focusing lens 24 constitute poles and pieces of a magnetic lens serving also as a magnetic yoke. With the addition of a non-magnetic electrode 19, these three electrodes 18, 19, 20 form an electrostatic lens. The electrodes 18, 20 have the same potential as the instrument column. When using ion beam operation, switches 38, 39, 16 are arranged so that the power source 15' produces a retarding potential at the electrode 19 which focuses the ion beams on the surface of work piece 13. For focusing electrons this lens 24 is used as a magnetic lens. With the above arrangement it is possible to improve the focusing power for both electrons and ions.

Though not shown in Figure 2, this embodiment also has a first electric source 6, 6', a second electric source 7, 7' and switches 8, 9, 10 as shown in Figure 1. With these it is possible to apply voltages between the tip 1 and the first electrode 11 and between the first electrode 11 and the second electrode 12. But the application of these voltages can be made simpler if, instead of providing separate power sources 6, 6', 7, 7', a source 15' is used in place of sources 6' and 7' and source 15 in place of sources 6 and 7, and a switch 9 is inserted between the two sources 15, 15'. Then the switch 38 performs the function of the switch 8, and the switch 39 the function of the switch 10. The position of the switch 16 is between the electrode 11 and earth.

Figure 2 also shows an insulating support 14 disposed between the first and second electrodes 11, 12 and an insulating support 17 for the tip formed of ceramics such as alumina, aligner electrodes 21 for correcting electron or ion optical axis deviation that may occur when the electron/ion switchover is effected due to errors in machining or construction accuracy and blanking electrodes 22 for controlling the beam exposition. Deflection electrodes 23 are provided for deflecting and scanning the beams. There is a primary evacuating pump 29 such as a sorption pump or rotary pump, a switchover valve 30, a rotary pump 31 for backward evacuating used when the pump 27 is a diffusion pump and an evacuating pump 36 such as an ion pump. A bellows 35 facilitates fine mechanical adjustment of the chamber 34 in the vacuum of the instrument column.

While the structure of cooling means for tip 1 is not shown, it can be present in the embodiment of Figure 2 as in conventional devices.

The charged particle source of this invention serving both as an electron source and an ion source can be used not only in electron beam instruments, scanning electron microscopes, electron beam fabricating instruments and electron probe micro-analysers but also in ion probe micro-analysers, ion beam lithography-fabrication instruments and ion beam micro-doping instruments using fine ion beams.

Thus with the beam source of the invention, it is possible to make a device which uses both electron beams and ion beams.

**Claims**

1. A charged particle source in an instrument column, in particular for microfabrication processes, comprising a charged particle generating chamber (34) situated within the instrument column, a tip (1) disposed inside the chamber (34) and functioning in a first mode of the charged particle source as an electron source and in a second mode of the charged particle source as a field ionization ion source, the tip material being carbide, nitride or di-boride of at least one of Ti, Zr, Hf, V, Nb and Ta or a hexa-boride of at least one of the rare earth elements of atomic number 57 to 70, a support (2) for the tip, a first electrode (11) for producing a field near the tip to draw out the charged particles generated, a second electrode (12) for accelerating and converging the charged particles drawn out by the first elctrode so as to provide a beam of the charged particles moving within the instrument column, a first electric power source (6, 6') connected between the tip and the first electrode, a second electric source (7, 7') connected between the first and second electrodes, switching means (8, 9) for changing substantially simultaneously the relative polarity of the tip and the first electrode and of the first and second electrodes when the operation of the charged particle source is changed between its said first and second modes so as to make the field positive or negative as appropriate, there being respective evacuation means (25, 27, 29, 36) for the charged particle generating chamber and the instrument column so that the charged particle generating chamber can be kept at a different degree of vacuum from the remainder of the instrument column volume.

2. A charged particle source according to claim 1, wherein the tip (1) is formed of a single crystal of a carbide of at least one of Ti, Zr, Hf, V, Nb and Ta.

3. A charged particle source according to claim 1 wherein the tip (1) is a single crystal of a nitride of at least one of Ti, Zr, Hf, V, Nb and Ta.

4. A charged particle source according to claim 1 wherein the tip (1) is a single crystal of a di-boride of at least one of Ti, Zr, Hf, V, Nb and Ta.

5. A charged particle source according to any one of claims 2 to 4 wherein the single crystal is a single crystal whisker.

6. A charged particle source according to claim 1 wherein the tip (1) is a single crystal of a hexa-boride of at least one of rare earth element of atomic number 57 to 70.

7. A charged particle source according to any one of the preceding claims wherein the tip support (2) is a filament which serves as a heater and a heat-conductor and, to heat and cool the support, an electric power source and cooling means are connected to the support.

8. A charged particle source according to any one of the preceding claims having in the instrument column a lens (18, 19, 20, 24) operable alternately as an electrostatic lens and as a magnetic lens to converge further the the said charged particles after they have been accelerated and converged by the second electrode.

**Patentansprüche**

1. Ladungsteilchen-Quelle in einer Instrumentensäule, insbesondere für Mikro-Herstellungsprozesse, mit einer Ladungsteilchen-Erzeugungskammer (34), die in der Instrumentensäule sitzt, einer Spitze (1), die im Inneren der Kammer (34) angeordnet ist und in einem ersten Betriebszustand der Ladungsteilchen-Quelle als eine Elektronenquelle und in einem zweiten Betriebszustand der Ladungsteilchen-Quelle als eine Feldionisations-Ionenquelle funktioniert, wobei das Spitzenmaterial ein Karbid, ein Nitrid oder ein Di-Borid von zumindest einem von Ti, Zr, Hf, V, Nb und Ta oder ein Hexa-Borid von zumindest einem der Seltenerd-Elemente mit der Atomzahl 57 bis 70 ist, einem Träger (2) für die Spitze, einer ersten Elektrode (11) zur Erzeugung eines Feldes in der Nähe der Spitze, um die erzeugten Ladungsteilchen herauszuziehen, einer zweiten Elektrode (12) zum Beschleunigen und Konvergieren der durch die erste Elektrode herausgezogenen Ladungsteilchen, um einen sich in der Instrumentensäule bewegenden Strahl der Ladungsteilchen zu schaffen, einer ersten elektrischen Leistungsquelle (6, 6'), die zwischen die Spitze und die erste Elektrode geschaltet ist, einer zweiten elektrischen Quelle (7, 7'), die zwischen die erste und die zweite Elektrode geschaltet ist, einer Schalteinrichtung (8, 9), um im wesentlichen gleichzeitig die relative Polarität der Spitze und der ersten Elektrode sowie der ersten und der zweiten Elektrode zu verändern, wenn der Betrieb der Ladungsteilchen-Quelle zwischen ihrem ersten und ihrem zweiten Betriebszustand verändert wird, um das Feld entsprechend positiv oder negativ zu machen, wobei jeweilige Evakuiereinrichtungen (25, 27, 29, 36) für die Ladungsteilchen-Erzeugungskammer und die Instrumentensäule vorgesehen sind, so daß die Ladungsteilchen-Erzeugungskammer auf einem sich vom Rest des Instrumentensäulen-Volumens unterscheidenden Vakuumgrad gehalten werden kann.

2. Ladungsteilchen-Quelle nach Anspruch 1, wobei die Spitze (1) aus einem Einkristall eines Karbids von zumindest einem von Ti, Zr, Hf, V, Nb und Ta gebildet ist.

3. Ladungsteilchen-Quelle nach Anspruch 1, wobei die Spitze (1) ein Einkristall eines Nitrids von zumindest einem von Ti, Zr, Hf, V, Nb und Ta ist.

4. Ladungsteilchen-Quelle nach Anspruch 1, wobei die Spitze (1) ein Einkristall eines Di-Borids von zumindest einem von Ti, Zr, Hf, V, Nb und Ta ist.

5. Ladungsteilchen-Quelle nach einem der Ansprüche 2 bis 4, wobei der Einkristall ein Whisker-Einkristall ist.

6. Ladungsteilchen-Quelle nach Anspruch 1, wobei die Spitze (1) ein Einkristall eines Hexa-Borids von zumindest einem der Seltenerd-Elemente der Atomzahl 57 bis 70 ist.

7. Ladungsteilchen-Quelle nach einem der vorhergehenden Ansprüche, wobei der Spitzen-Träger (2) ein Faden ist, der als ein Heizkörper und als ein Heizleiter dient, und wobei zum Heizen und Kühlen des Trägers eine elektrische Leistungsquelle und eine Kühleinrichtung mit dem Träger verbunden sind.

8. Ladungsteilchen-Quelle nach einem der vorhergehenden Ansprüche mit einer Linse (18, 19, 20, 24) in der Instrumentensäule, die abwechselnd als eine elektrostatische Linse und als eine magnetische Linse zu betreiben ist, um die Ladungsteilchen weiter zu konvergieren, nachdem sie durch die zweite Elektrode beschleunigt und konvergiert wurden.

## Revendications

1. Source de particules chargées placée dans une colonne d'un appareil, en particulier pour des procédés de fabrication microscopique, comprenant une chambre (34) de production de particules chargées, située à l'intérieur de la colonne de l'appareil, une pointe (1) disposée à l'intérieur de la chambre (34) et fonctionnant, dans un premier mode de fonctionnement de la source de particules chargées, en tant que source d'électrons et, dans un second mode de fonctionnement de la source de particules chargées, en tant que source d'ions réalisant une ionisation de champ, le matériau de la pointe étant un carbure, un nitrure ou un diborure d'au moins l'un des éléments Ti, Zr, Hf, V, Nb et Ta ou un hexaborure d'au moins l'un des éléments des terres rares possédant un numéro atomique compris entre 57 et 70, un support (2) pour la pointe, une première électrode (11) servant à produire un champ à proximité de la pointe afin d'extraire les particules chargées produites, une seconde électrode (12) servant à accélérer et faire converger les particules chargées extraites par la première électrode de manière à obtenir un faisceau des particules chargées se déplaçant à l'intérieur de la colonne de l'appareil, une première source d'énergie électrique (6, 6') branchée entre la pointe et la première électrode, une seconde source électrique (7, 7') branchée entre les première et seconde électrodes, des moyens de commutation (8, 9) servant à modifier sensiblement simultanément la polarité relative de la pointe et de la première électrode et des première et seconde électrodes lorsque le fonctionnement de la source de particules chargées est commutée entre lesdits premier et seond modes de manière à le champ positif ou négatif comme cela s'avère approprié, des moyens respectifs (25, 27, 29, 36) de formation d'un vide étant prévus pour la chambre de production des particules chargées et pour la colonne de l'appareil, de sorte que la chambre de production des particules chargées peut être maintenue à un degré différent de vide par rapport au reste du volume de la colonne de l'appareil.

2. Source de particules chargées selon la revendication 1, dans laquelle la pointe (1) est formée par un monocristal d'un carbure de l'un au moins des éléments Ti, Zr, Hf, V, Nb, et Ta.

3. Source de particules chargées selon la revendication 1, dans laquelle la pointe (1) est un monocristal d'un nitrure d'au moins l'un des éléments Ti, Zr, Hf, V, Nb et Ta.

4. Source de particules chargées selon la revendication 1, dans laquelle la pointe (1) est un monocristal d'un diborure d'au moins l'un des éléments Ti, Zr, Hf, V, Nb et Ta.

5. Source de particules chargées selon l'une quelconque des revendications 1 à 4, dans laquelle le monocristal est un whisker monocristallin.

6. Source de particules chargées selon la revendication 1, dans laquelle la pointe (1) est un monocristal d'un hexaborure d'au moins un élément des terres rares possédant un numéro atomique compris 57 et 70.

7. Source de particules chargées selon l'une quelconque des revendications précédentes, dans laquelle le support (2) de la pointe est un filament qui sert de dispositif de chauffage et de conducteur de chaleur et, pour réaliser le chauffage et le refroidissement du support, une source d'énergie électrique et des moyens de refroidissement sont raccordés au support.

8. Source de particules chargées selon l'une quelconque des revendications précédentes, comportant, dans la colonne de l'appareil, une lentille (18, 19, 20, 24) pouvant fonctionner en alternance en tant que lentille électrostatique et en tant que lentille magnétique pour faire converger de façon supplémentaire lesdites particules chargées après que la seconde électrode les a accélérées et les a fait converger.

0 066 409

*FIG. 1*

*FIG. 2*

1